# EUROPÄISCHE PATENTSCHRIFT

(11) **EP 0 735 507 B1**
(45) Veröffentlichungstag und Bekanntmachung des Hinweises auf die Patenterteilung: **16.08.2000**
(21) Anmeldenummer: 96100803.4
(22) Anmeldetag: 20.01.1996
(51) Int. Cl.: G06K 19/077, G06K 7/06

(54) **Kontaktiereinheit für kartenförmige Trägerelemente**
Contact unit for card-form carrier elements
Unité de contact pour éléments porteurs en forme de carte

(30) Priorität: 01.04.1995 DE 29505678 U
(43) Veröffentlichungstag der Anmeldung: 02.10.1996
(73) Patentinhaber: STOCKO Contact GmbH & Co. KG, 42327 Wuppertal (DE)
(72) Erfinder: Klatt, Dieter, D-42489 Wülfrath (DE); Pelke, Bernhard, D-42119 Wuppertal (DE)
(74) Vertreter: Stenger, Watzke & Ring Patentanwälte

(56) Entgegenhaltungen:
- EP-A- 0 214 478
- EP-A- 0 433 688
- EP-A- 0 552 078
- EP-A- 0 609 974
- EP-A- 0 635 801
- DE-A- 3 528 558
- DE-A- 4 310 517
- DE-U- 9 012 889
- US-A- 5 473 505

## Beschreibung

Die Erfindung betrifft eine Kontaktiereinheit für kartenförmige Trägerelemente elektronischer Baugruppen, mit einer Basisplatte, deren Breite im Einschubbereich der Basisplatte in ein elektronisches Verarbeitungsgerät der Breite des aufzunehmenden kartenförmigen Trägerelements entspricht, sowie mit wenigstens einer im wesentlichen parallel zu Basisplatte angeordneten Leiterplatte die an einer Oberfläche Kontaktelemente für die elektronischen Baugruppen des kartenförmigen Trägerelements aufweist und mit einem an einer Kante der Basisplatte angeordneten Anschlußfeld verbunden ist.

Insbesondere im Bereich der Computertechnologie werden elektronische Baugruppen vorzugsweise auf kartenförmigen Trägerelementen angeordnet. Diese Trägerelemente weisen Kontaktbereiche auf und sind in Kontaktiereinheiten einschiebbar, wo sie elektrisch kontaktiert und in den Datenkreislauf integriert werden. Es sind kartenförmige Trägerelemente nach der sogenannten PCMCIA-Norm bekannt, wobei es sich um Karten handelt, die einen normgemäßes matrixartiges Anschlußkontaktfeld aufweisen und unterschiedlichste IC-Schaltkreise aufnehmen können. Derartige Karten können Speichererweiterungskarten, Laufwerkskarten, Modemkarten und dergleichen sein. Sie lassen sich in Kontaktiereinheiten mit einer entsprechenden Stiftmatrix kontaktieren, wozu sie in den Einschubschlitz beispielsweise eines Computers eingeschoben werden. Auch sind sogenannte Chip-Karten bekannt, wie sie derzeit beispielsweise als Telefonkarten und dergleichen Verwendung finden. Diese weisen flächig angeordnete Kontaktfelder für die Kontaktierung eines Chips auf und werden ebenfalls in insbesondere als Leseeinheiten ausgebildete Kontaktiereinheiten eingeschoben. In neuester Zeit ist auch die Kombination bekannter Kartensysteme bekannt, wobei beispielsweise gleichzeitig eine PCMCIA- und eine Chip-Karte in eine entsprechende Kontaktiereinheit eingeschoben werden.

Bezüglich der Kombination der Kartensysteme ist es aus der EP 0 552 078 A1 bekannt, eine PCMCIA-Karte in dem vom Anschlußfeld wegweisenden Bereich mit einer Ausnehmung für eine Chip-Karte zu versehen. Gleichzeitig wird an der im Bereich der Ausnehmung freiliegenden Oberfläche ein Feld aus Kontaktelementen für die elektronischen Baugruppen der Chip-Karte angeordnet. Diese Entwicklung sieht vor, beide Karten aufeinanderliegend in den Einschubschlitz beispielsweise eines Computers im Bereich eines Kontaktfeldes einzuschieben oder die Chip-Karte bei eingeschobener PCMCIA-Karte zu wechseln. Nachteilig ist hier das Freiliegen des Kontaktfeldes und die mangelnde Führung der Chip-Karte, die darüber hinaus auch in ihrer Betriebsposition relativ zur PCMCIA-Karte bewegbar ist, so daß eine sichere Kontaktierung nicht gewährleistet werden kann.

Die DE-OS 43 10 517 schlägt vor, bei einer wie aus der EP 0 552 078 A1 bekannten PCMCIA-Karte den dem Anschlußfeld entgegengesetzten Bereich, welcher in der Betriebsposition der PCMCIA-Karte definitionsgemäß aus dem Gehäuse herauszustehen hat, so zu vergrößern, daß ein Führungsschlitz für eine Chip-Karte gebildet werden kann. Dieser Vorschlag weicht jedoch von der normierten Ausgestaltung einer PCMCIA-Karte ab und kann darüber hinaus ebenfalls nicht sicherstellen, daß die Chip-Karte aus der Führungsebene nicht herauskippbar ist. Soweit auch innere Führungsplatten vorgeschlagen werden, stößt die Chip-Karte beim Einschieben gegen diese Plattenelemente an. Ein sicherer Betrieb im Sinne einer Vielfachbetätigung an Automaten und dergleichen kann mit den vorbekannten Vorrichtungen nicht gewährleistet werden.

Es sind auch Vorschläge bekannt, die Gehäuse von PCMCIA-Karten wenigstens zweiteilig auszugestalten, um durch entsprechende Dimensionierungen der einzelnen Teile Führungskanäle auszubilden. Diese Bauform ist nur mit großem wirtschaftlichen Aufwand herstellbar und nicht für eine billige Massenproduktion im Sinne einer umfangreichen Verwendung vorbekannter Kartensysteme geeignet.

Ausgehend von diesem Stand der Technik liegt der vorliegenden Erfindung die **Aufgabe** zugrunde, eine Kontaktiereinheit der gattungsgemäßen Art dahingehend weiterzubilden, daß diese mit geringem wirtschaftlichen Aufwand herstellbar und einfach und sicher verwendbar ist, wobei bei sachgemäßer Verwendung eine sichere Kontaktierung mit einem kartenförmigen Trägerelement gewährleistet ist.

Zur technischen **Lösung** dieser Aufgabe wird eine Kontaktiereinheit gemäß Anspruch 1 vorgeschlagen.

Die Kontaktiereinheit wird aus einfachen Elementen aufgebaut, die jedes für sich kostengünstig herstellbar sind. Eine Basisplatte, beispielsweise mit den normgemäßen PCMCIA-Karten-Abmessungen hinsichtlich der Länge und der Breite dient zumindest der Aufnahme einer Leiterplatte und eines Anschlußfeldes, wobei das Anschlußfeld im Bereich einer Kante der Basisplatte an dieser angeordnet ist. In Einschubrichtung gesehen ist dies regelmäßig die Hinterkante der Basisplatte. Die Leiterplatte weist ein Feld aus Kontaktelementen auf, die auf einer Oberfläche angeordnet sind, die zweckmäßigerweise die von der Basisplatte wegweisende Oberfläche ist. Die Leiterplatte liegt planparallel in oder auf der Basisplatte und wird in dieser Position an der Basisplatte fixiert. Ein plattenförmiges Abdeckelement, welches im wesentlichen die Ausdehnungen der Basisplatte hat, wird einerseits im Bereich der Kante, an der an der Basisplatte das Anschlußfeld angeordnet ist, befestigt, also beispielsweise am Anschlußfeld, und wenigstens im Bereich der dieser Kante gegenüberliegenden Ecken, in Einschubrichtung gesehen also den vorderen Ecken. Es entsteht somit ein Einschubkanal für eine Chip-Karte, die zwischen der Abdeckplatte und der Leiterplatte einschiebbar ist. Gleichzeitig wird sie seitlich geführt, da die Basisplatte und die Abdeckplatte im Bereich der vorderen Ecken in Verbindung stehen.

Die auf der Leiterplatte angeordneten Kontaktelemente sind somit beim Transport der Kontaktiereinheit geschützt und im Betrieb beispielsweise gegen Staubansammlungen gesichert. Die Chip-Karte kann nur in einer definierten Weise eingeschoben werden und wird sowohl seitlich als auch in der Flächenebene geführt und somit sicher kontaktiert. Die einzelnen Elemente zur Erstellung der Kontaktiereinheit sind für sich einfach und kostengünstig herstellbar.

Gemäß einem vorteilhaften Vorschlag der Erfindung ist zwischen der Basisplatte und dem Abdeckelement im Bereich der dem Anschlußfeld entgegengesetzten Kante ein Einschubschlitz angeordnet. Durch diese Maßnahme wird die Sicherheit beim Einführen einer Chip-Karte verbessert. In vorteilhafter Weise ist die Verbindung der einzelnen Elemente lösbar ausgestaltet. Durch diese Maßnahme kann die modular aufgebaute Kontaktiereinheit einfach umgestaltet oder gewartet werden. Dies wird noch dadurch begünstigt, daß das Abdeckelement gemäß einem weiteren vorteilhaften Vorschlag der Erfindung aus Segmenten aufgebaut ist. Das Abdeckelement kann ein plattenförmiges Element aus Metall oder Kunststoff sein.

Gemäß einem Vorschlag der Erfindung weist das Abdeckelement in dem Bereich, in dem es am Anschlußfeld angeordnet wird, eine Kröpfung auf. Diese läuft im wesentlichen parallel zur Hinterkante und bildet somit eine Schräge in dem hinteren Bereich, an welcher eine eingeschobene Chip-Karte von dem Abdeckelement weggedrückt wird. Gleichzeitig wird die Chip-Karte zur Leiterplatte hin und damit auf die Kontaktelemente gedrückt. Die Kontaktiersicherheit wird dadurch erheblich erhöht.

Gemäß einem weiteren Vorschlag der Erfindung ist an der Leiterplatte ein zweites Kontaktfeld für ein zweites Trägerelement ausgebildet. In besonders vorteilhafter Weise ist im Bereich dieses zweiten Kontaktfeldes eine Ausnehmung für eine Plug-in-Karte ausgebildet. Durch diese Maßnahme können in der Kontaktiereinheit, die ihrerseits kartenförmig ausgebildet und in Einschubschlitze von Verarbeitungsanlagen einsetzbar ist, gleichzeitig zwei Chip-Karten gleicher oder unterschiedlicher Größe eingesetzt werden. Dies erhöht die Verwendungssicherheit der Systeme, da die Verwendung einer Karte von dem Einsatz einer anderen Karte abhängig gemacht werden kann.

Gemäß einem weiteren vorteilhaften Vorschlag sind in dem Abdeckelement elastische Elemente im Bereich der Oberfläche ausgebildet, die den an der Leiterplatte angeordneten Kontaktelementen gegenüberliegt. Durch diese Maßnahme wird eine eingeschobene Chip-Karte verstärkt an das Kontaktfeld herangedrückt. Mit besonderem Vorteil können die elastischen Elemente, beispielsweise Federelemente, als elektrisches Kontaktelement ausgestaltet sein. Schließlich können die elastischen Elemente als Sicherungselement ausgebildet sein. Wird ein Federelement als elektrisches Kontaktelement ausgebildet, kann die Anwesenheit einer auszuwertenden Chip-Karte zusätzlich festgestellt werden. Bei der Verwendung als Sicherheitselement kann das Federelement beispielsweise mit einer in der Chip-Karte ausgebildeten Ausnehmung zusammenwirken und somit wie ein Kodierschloß funktionieren.

Mit der Erfindung wird eine mit einfachen Mitteln und wirtschaftlich herstellbare Kontaktiereinheit für kartenförmige Trägerelemente elektronischer Baugruppen vorgeschlagen, die die Betriebssicherheit erheblich verbessert.

Weitere Vorteile und Merkmale der Erfindung ergeben sich aus der folgenden Beschreibung anhand der Figuren. Dabei zeigen:
- Figur 1: eine perspektivische Darstellung eines Ausführungsbeispieles der Erfindung;
- Figur 2: eine schematische Schnittdarstellung des Ausführungsbeispiels gemäß Figur 1 in einer ersten Position;
- Figur 3: eine schematische Schnittdarstellung des Ausführungsbeispiels gemäß Figur 1 in einer zweiten Position;
- Figur 4: eine perspektivische Darstellung einer Abdeckplatte und
- Figur 5: eine perspektivische Darstellung eines weiteren Ausführungsbeispiels.

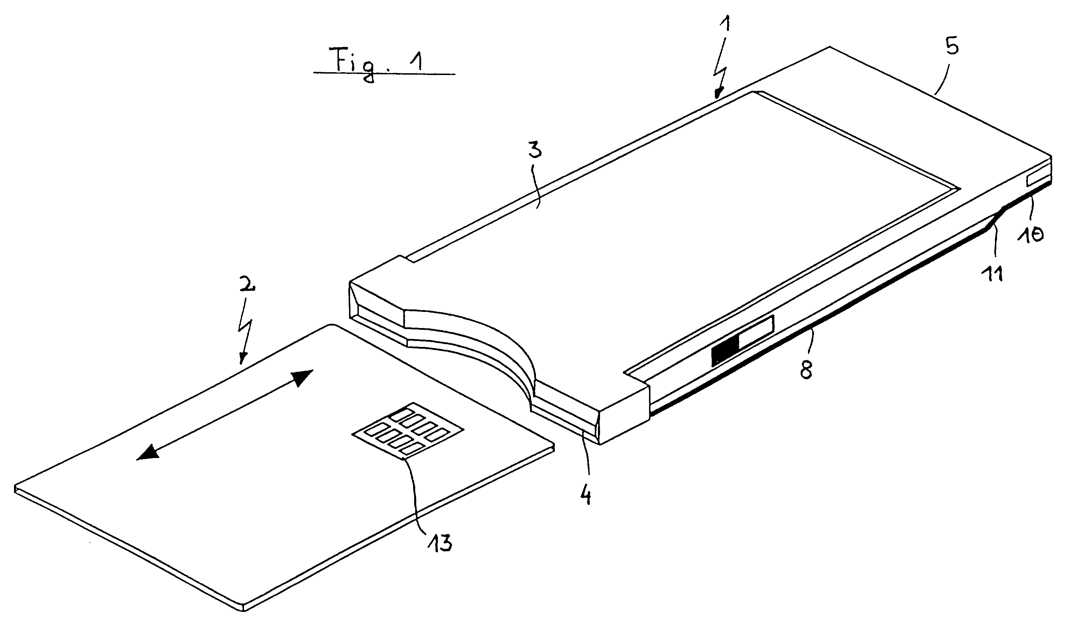

Mit Bezug auf die Figuren 1 bis 3 wird ein Ausführungsbeispiel der Erfindung beschrieben. Eine Kontaktiereinheit, im gezeigten Ausführungsbeispiel eine PCMCIA-Karte 1, die der Kontaktierung einer Chip-Karte 2 dient, auf welcher ein Chipfeld 13 angeordnet ist, weist eine Basisplatte 3 auf, die im vorderen Bereich einen Einschubschlitz 4 umfaßt und an deren in Einschubrichtung gesehen hinteren Bereich ein Anschlußfeld 5 ausgebildet ist. Die Chip-Karte 2 läßt sich in Richtung des gezeigten Doppfelpfeiles in die PCMCIA-Karte 1 einführen und aus dieser herausziehen. Im gezeigten Ausführungsbeispiel ist der Einschubschlitz 4 als mit der Basisplatte 3 einstückig ausgebildetes Element gezeigt. Dieser Einschubschlitz 4 ist optional und braucht auch nicht als integriertes Bauteil ausgeführt sein. Im Inneren der PCMCIA-Karte ist eine mit dem Anschlußfeld 5 verbundene Leiterplatte 6 planparallel zur Basisplatte 3 angeordnet und weist Kontaktelemente 7 zur Kontaktierung des Chipfeldes 13 auf. Somit kann die Chip-Karte über die PCMCIA-Karte verarbeitet werden, wenn die letztgenannte in den Einschubschlitz eines elektronischen Verarbeitungsgerätes und über das Anschlußfeld 5 dort mit einen entsprechenden Kontaktfeld verbunden ist. Anwendungsbeispiele ergeben sich aus dem Bereich der Kommunikation, der Banken und dergleichen.

Ebenfalls planparallel und mit der Leiterplatte 6 einen Einschubkanal für die Chip-Karte 2 bildend ist eine Abdeckplatte 8 angeordnet, die im Bereich des Anschlußfeldes 5 und im Bereich der dieser Kante gegenüberliegenden Ecken, im gezeigten Ausführungsbeispiel über den Befestigungsbereich 15, mit der Basisplatte 3 in Verbindung steht.

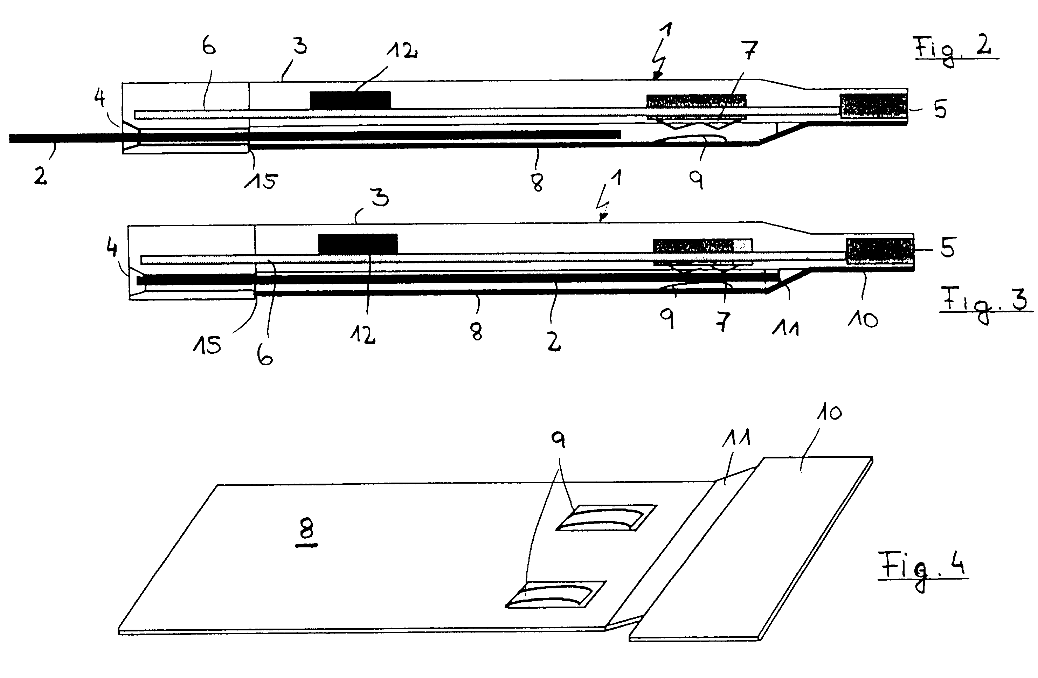

Wie in Figur 4 gezeigt ist, weist die Basisplatte 8 Federelemente 9 auf, die im Bereich der Oberfläche der Abdeckplatte 8 angeordnet sind, die im wesentlichen dem Feld der Kontaktelemente gegenüber liegt. Somit wird ein Andrücken der Chip-Karte im Kontaktierbereich gewährleistet. Weiterhin weist die Abdeckplatte im Bereich des Anschlußfeldes die Fixierplatte 10 auf, die der Befestigung dient, und davor gelagert den Kröpfungsbereich 11, so daß sich eine Auflaufschräge für die eingeführte Chip-Karte ergibt, so daß diese zusätzlich noch an die Kontaktelemente 7 herangedrückt wird, wenn sie, wie in Figur 3 gezeigt ist, voll eingeschoben ist.

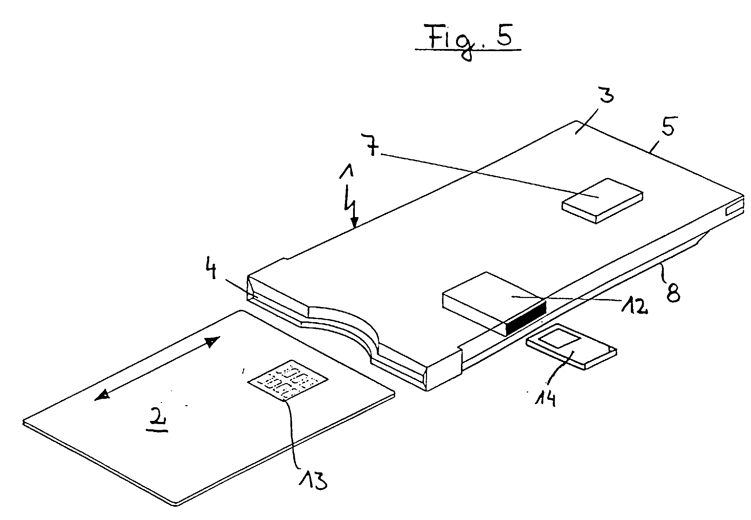

Bei dem in Figur 5 gezeigten Ausführungsbeispiel, welches dem in Figur 1 gezeigten Ausführungsbeispiel im wesentlichen entspricht, ist zusätzlich noch ein zweiter Einschubbereich in Form eines Schlitzes 12 für eine sogenannte Plug-in-Karte 14 vorgesehen. Es können somit in die Kontaktiereinheit, im gezeigten Ausführungsbeispiel in Form einer PCMCIA-Karte 1, gleichzeitig zwei Chip-Karten eingeführt werden.

Die Anwendungsbereiche sind vielfältig. So kann eine der Chip-Karten eine Authorisierungskarte sein, während die andere beispielsweise eine Kontokarte ist, von der Beträge abbuchbar sind. Die Kontaktiereinheit ihrerseits kann in verschiedene Vorrichtungen wie Parkuhr, Pkw, Bus, Fernsehen und dergleichen eingesetzt werden, um so die Buchungen ausführen zu lassen.

## Patentansprüche

1. Kontaktiereinheit, insbesondere nach der PCMCIA-Norm, für kartenförmige Trägerelemente (2) elektronischer Baugruppen (13), mit einer Basisplatte (3), deren Breite im Einschubbereich der Basisplatte (3) in ein elektronisches Verarbeitungsgerät der Breite des aufzunehmenden kartenförmigen Trägerelements (2) entspricht, sowie mit wenigstens einer im wesentlichen parallel zu Basisplatte (3) angeordneten Leiterplatte (6), die an einer Oberfläche Kontaktelemente (7) für die elektronischen Baugruppen (13) des kartenförmigen Trägerelements (2) aufweist und mit einem an einer Kante der Basisplatte (3) angeordneten Anschlußfeld (5) verbunden ist,
**gekennzeichnet durch**
ein plattenförmiges, zur Basisplatte (3) deckungsgleiches Abdeckelement (8), das mit der Basisplatte (3) ausschließlich im Bereich der das Anschlußfeld (5) aufnehmenden Kante und im Bereich der dieser Kante gegenüberliegenden Ecken (15) verbunden ist, wobei die zwischen Basisplatte (3) und Abdeckelement (8) angeordnete Leiterplatte (6) zusammen mit dem Abdeckelement (8) einen schlitzartigen Einschubkanal für das kartenförmige Trägerelement (2) bildet und ein in diesem Einschubkanal aufgenommenes kartenförmiges Trägerelement (2) ausschließlich im Bereich der die Basisplatte (3) und das Abdeckelement (8) miteinander verbindenden, dem Anschlußfeld (5) gegenüberliegenden Ecken (15) seitlich geführt ist.

2. Kontaktiereinheit nach Anspruch 1, dadurch gekennzeichnet, daß an der dem Anschlußfeld entgegengesetzten Kante an der Basisplatte und dem Abdeckelement ein Einschubschlitzelement angeordnet ist.

3. Kontaktiereinheit nach einem der vorhergehenden Ansprüche, dadurch gekennzeichnet, daß die Basisplatte und das Abdeckelement lösbar miteinander verbunden sind.

4. Kontaktiereinheit nach einem der vorhergehenden Ansprüche, dadurch gekennzeichnet, daß das Abdeckelement aus Segmenten gebildet ist.

5. Kontaktiereinheit nach einem der vorhergehenden Ansprüche, dadurch gekennzeichnet, daß das Abdeckelement aus Metall gebildet ist.

6. Kontaktiereinheit nach einem der Ansprüche 1 bis 4, dadurch gekennzeichnet, daß das Abdeckelement aus Kunststoff gebildet ist.

7. Kontaktiereinheit nach einem der vorhergehenden Ansprüche, dadurch gekennzeichnet, daß das Abdeckelement im Bereich der am Anschlußfeld anzuordnenden Kante mit einer Kröpfung versehen ist.

8. Kontaktiereinheit nach einem der vorhergehenden Ansprüche, dadurch gekennzeichnet, daß an der Leiterplatte wenigstens ein zweites Feld von Kontaktelementen ausgebildet ist.

9. Kontaktiereinheit nach einem der vorhergehenden Ansprüche, dadurch gekennzeichnet, daß diese eine Ausnehmung für eine Plug-in-Karte aufweist.

10. Kontaktiereinheit nach einem der vorhergehenden Ansprüche, dadurch gekennzeichnet, daß das Abdeckelement in seiner Oberfläche wenigstens ein elastisches Element aufweist.

11. Kontaktiereinheit nach Anspruch 10, dadurch gekennzeichnet, daß das wenigstens eine elastische Element ein Federelement ist.

12. Kontaktiereinheit nach einem der Ansprüche 10 oder 11, dadurch gekennzeichnet, daß das wenigstens eine elastische Element elektrisch kontaktierbar ist.

13. Kontaktiereinheit nach einem der vorhergehenden Ansprüche, dadurch gekennzeichnet, daß diese wenigstens ein Sicherungselement aufweist.

## Claims

1. Contacting unit, in particular according to the PCMCIA standard, for card-like substrate elements (2) for electronic packages (13), with a base board (3) whose width in the region of insertion of the base board (3) in an item of electronic processing equipment corresponds to the width of the card-like substrate element (2) to be received, and with at least one printed circuit board (6) which is arranged essentially parallel to the base board (3) and which on one surface comprises contact elements (7) for the electronic packages (13) of the card-like substrate element (2) and is connected to a terminal area (5) arranged at one edge of the base board (3), characterised by a board-like cover element (8) which is in register with the base board (3) and which is connected to the base board (3) exclusively in the region of the edge receiving the terminal area (5) and in the region of the corners (15) opposite this edge, wherein the printed circuit board (6) arranged between base board (3) and cover element (8) forms together with the cover element (8) a slot-like insertion channel for the card-like substrate element (2), and a card-like substrate element (2) held in this insertion channel is laterally guided exclusively in the region of the corners (15) connecting the base board (3) and the cover element (8) to each other and located opposite the terminal area (5).

2. Contacting unit according to claim 1, characterised in that at the edge opposite the terminal area, on the base board and the cover element, is arranged an insertion slot element.

3. Contacting unit according to any of the preceding claims, characterised in that the base board and the cover element are releasably connected to each other.

4. Contacting unit according to any of the preceding claims, characterised in that the cover element is formed from segments.

5. Contacting unit according to any of the preceding claims, characterised in that the cover element is made of metal.

6. Contacting unit according to any of claims 1 to 4, characterised in that the cover element is made of plastic.

7. Contacting unit according to any of the preceding claims, characterised in that the cover element is provided with an offset in the region of the edge to be arranged on the terminal area.

8. Contacting unit according to any of the preceding claims, characterised in that on the printed circuit board is formed at least one second area of contact elements.

9. Contacting unit according to any of the preceding claims, characterised in that it comprises a recess for a plug-in board.

10. Contacting unit according to any of the preceding claims, characterised in that the cover element in its surface comprises at least one resilient element.

11. Contacting unit according to claim 10, characterised in that the at least one resilient element is a spring element.

12. Contacting unit according to either of claims 10 or 11, characterised in that the at least one resilient element can be contacted electrically.

13. Contacting unit according to any of the preceding claims, characterised in that it comprises at least one fuse element.

## Revendications

1. Unité de contact, en particulier selon la norme PCMCIA, pour éléments porteurs en forme de carte (2) de composants électroniques (13), comprenant une plaque de base (3) dont la largeur, dans la région d'insertion de la plaque de base (3) dans un appareil de traitement électronique, correspond à la largeur de l'élément porteur en forme de carte (2) à recevoir, et comprenant au moins une plaque de circuit imprimé (6) qui est disposée de manière sensiblement parallèle à la plaque de base (3), qui comporte, sur l'une de ses surfaces, des éléments de contact (7) pour les composants électroniques (13) de l'élément porteur en forme de carte (2) et qui est reliée à un socle de connexion (5) disposé sur un chant de la plaque de base (3), caractérisée par un élément de recouvrement en forme de plaque (8) qui coïncide avec la plaque de base (3) et qui n'est relié à ladite plaque de base (3) que dans la région du chant recevant le socle de connexion (5) et dans la région des coins (15) situés à l'opposé dudit chant, la plaque de circuit imprimé (6) disposée entre la plaque de base (3) et l'élément de recouvrement (8) formant, conjointement avec ledit élément de recouvrement (8), un canal d'insertion en forme de fente pour l'élément porteur en forme de carte (2), et un élément porteur en forme de carte (2) logé dans ledit canal d'insertion n'étant guidé latéralement que dans la région des coins (15) qui est située à l'opposé du socle de connexion (5) et qui relie entre eux la plaque de base (3) et l'élément de recouvrement (8).

2. Unité de contact selon la revendication 1, caractérisée en ce qu'un élément formant fente d'insertion est disposé sur la plaque de base et sur l'élément de recouvrement au niveau du chant situé à l'opposé du socle de connexion.

3. Unité de contact selon une des revendications précédentes, caractérisée en ce que la plaque de base et l'élément de recouvrement sont reliés entre eux de manière détachable.

4. Unité de contact selon une des revendications précédentes, caractérisée en ce que l'élément de recouvrement est formé de segments.

5. Unité de contact selon une des revendications précédentes, caractérisée en ce que l'élément de recouvrement est réalisé en métal.

6. Unité de contact selon l'une des revendications 1 à 4, caractérisée en ce que l'élément de recouvrement est réalisé en matière plastique.

7. Unité de contact selon une des revendications précédentes, caractérisée en ce que l'élément de recouvrement est pourvu d'un décrochement dans la région du chant destiné à être disposé au niveau du socle de connexion.

8. Unité de contact selon une des revendications précédentes, caractérisée en ce qu'au moins un second socle d'éléments de contact est prévu sur la plaque de circuit imprimé.

9. Unité de contact selon une des revendications précédentes, caractérisée en ce qu'elle est pourvue d'un évidement pour une carte enfichable.

10. Unité de contact selon une des revendications précédentes, caractérisée en ce que l'élément de recouvrement comporte, dans sa surface, au moins un élément élastique.

11. Unité de contact selon la revendication 10, caractérisée en ce que l'élément élastique, au nombre d'au moins un, est un élément à ressort.

12. Unité de contact selon l'une des revendications 10 ou 11, caractérisée en ce que l'élément élastique, au nombre d'au moins un, peut être mis en contact électriquement.

13. Unité de contact selon une des revendications précédentes, caractérisée en ce qu'elle comporte au moins un élément de sécurité.
